# EUROPEAN PATENT APPLICATION

(11) **EP 3 975 424 A1**
(43) Date of publication of application: **30.03.2022**
(21) Application number: 20197539.8
(22) Date of filing: 22.09.2020
(51) Int. Cl.: H03K 3/037, H03K 19/096, H03K 19/003

(54) **CORRIGIBLE COMPARATOR FOR TRIPLE MODULAR REDUNDANCY CELL**

(30) Priority: 04.09.2020 EP 20194684
(71) Applicant: IHP GmbH - Innovations for High Performance Microelectronics / Leibniz-Institut für innovative Mikroelektronik, 15236 Frankfurt (Oder) (DE)
(72) Inventor: Schrape, Oliver, 15236 Frankfurt (Oder) (DE); Breitenreiter, Anselm, 15236 Frankfurt (Oder) (DE); Andjelkovic, Marko, 15236 Frankfurt (Oder) (DE); Krstic, Milos, 15236 Frankfurt (Oder) (DE)
(74) Representative: Eisenführ Speiser

(57) **Abstract**

The invention is directed to a corrigible comparator (100). The comparator comprises a data-forwarding stage configured to provide in dependence on a clock-based forwarding trigger event a first comparison binary value (Ax) that is correlated to a current binary value of input binary data signal (D). In a comparison stage, this value is compared to an external second comparison binary value (Bx) and an output binary value (Qx) that is correlated to the first comparison binary value (Ax) is provided when the compared values are identical. A feedback binary value (SCx) correlated to the first comparison binary value (Ax) is provided. A correction stage (Fx) is configured to receive external feedback binary values (SCy, SCz) and, depending on a correction trigger event, to provide to the comparison stage a corrected binary value (Ax') correlated to the feedback binary values when they have the same binary value.

## Description

The present invention is directed to a corrigible comparator, to a method for operating said corrigible comparator and to a self-correcting triple modular redundancy cell.

A triple modular redundancy system includes a triplication of sensitive logic that is connected to a majority voter. C. Ramamurthy, A. Gujja, V. Vashishtha, S. Chellappa, and L. T. Clark "Muller c-element self-corrected triple modular redundant logic with multithreading and low power modes" 2917 17th European Conference on Radiation and its Effects on Components and Systems (RADECS), pages 1-4, Oct. 2017 describes voting feedback circuits for triple modular redundant (TMR) self-correcting flip-flops.

It would be beneficial to provide an alternative feedback circuit suitable for implementation in multiple redundancy modules that is subject to less signal propagation delay.

According to a first aspect of the present invention, a sequential state element in the form of a corrigible comparator is disclosed. The corrigible comparator comprises a data-forwarding stage that is configured to receive an input binary data signal and a clock signal and to generate and provide, in dependence on an occurrence of a clock-based forwarding trigger event in the received clock signal, a first comparison binary value that is correlated to the current binary value of input binary data signal.

The comparator also comprises a comparison stage that is configured to receive, at a comparison stage input interface, the first comparison binary value and an external second comparison binary value for comparing to the first comparison binary value and to provide, when the first and the second comparison binary values have an identical binary value, and via an output data interface, an output binary value that is correlated to the first comparison binary value. In addition, the comparison stage is configured to provide, via a feedback output interface, a feedback binary value correlated to the first comparison binary value.

The corrigible comparator further comprises a correction stage that is configured to receive the clock signal and two external feedback binary values and, during in dependence on an occurrence in the received clock signal of a clock-based correction trigger event different from the forwarding trigger event, to provide to the comparison stage input interface, as a corrected first comparison binary value, a corrected binary value correlated to the two external feedback binary values when the two external feedback binary values have the same binary value.

The input binary data signal is indicative of input binary data having, at any given moment, an input binary data value among two possible binary values, referred to herewithin as HIGH or "1" and LOW or "0". It is therefore a signal which at any given time is associated to one of the two possible binary values. The data- forwarding stage receives the input binary data signal and a clock signal, which at any given moment has also one of the two possible binary value. The date-forwarding stage is therefore advantageously configured to provide, in dependence on an occurrence of the forwarding trigger event, the output binary value when the first and the second comparison binary value have the same binary data. The first comparison binary value provided in dependence on the forwarding trigger event is thus always related in a same univocal way to the current binary value of the input binary data, as long as the corrigible comparator is not affected by errors such as, for example, single transient events or any radiation-related errors. The forwarding trigger event corresponds to a predetermined clock signal form, such as a predetermined level or a predetermined transition between levels or a predetermined combination of levels and transitions.

The first comparison binary value is provided to the comparison stage. The comparison stage is also configured to receive the external second comparison binary value and to compare the first and the second comparison value. The comparison stage is configured to provide the output binary value. The output binary value, is under these circumstances .i.e. when the first and the second comparison binary values coincide, a value univocally correlated to the first comparison binary value, and therefore also to the second comparison value. Also, the comparison stage is configured to provide a feedback binary value that is correlated to the first comparison binary value, irrespective of whether the first and the second comparison binary value coincide or not.

Further, the correction stage is advantageously configured to receive two external feedback binary values and the clock signal. A correction function takes place in dependence on an occurrence of a correction trigger event occurs and the two external feedback binary values received coincide. The correction trigger event corresponds to another predetermined clock signal form that is different from the forwarding trigger event. Thus, both the forwarding event and the correction event cannot take place simultaneously. The comparison stage thus receives the first comparison binary value during occurrence of the forwarding trigger event and the corrected binary value during the occurrence of the correction trigger event. Based on the binary values of the two external feedback binary values, the first comparison binary value can be overwritten or confirmed or left as it is during the correction trigger event.

The corrigible comparator of the first aspect of the invention is therefore advantageously configured to integrate the provision of a voted output binary value and the feedback binary value in a single comparison stage thereby reducing a propagation delay and silicon area compared to known sequential state elements capable of providing a self-correction function in triple modular redundant cells.

In the following, embodiments of the corrigible comparator of the first aspect will be described.

In one embodiment, the input binary data signal is a single data input signal. In an alternative embodiment, the corrigible comparator is additionally configured to receive auxiliary binary input signals. In an embodiment these auxiliary binary input signals are asynchronous binary signals such as a set and/or a reset signal. Moreover, in this particular embodiment, the corrigible comparator is configured, if indicated by a predetermined value of the set signal, to provide an output binary value and a feedback binary value of HIGH, independently of the value of the input binary data signal value of the clock signal. Additionally, or alternatively, in another embodiment, the comparator is configured, if indicated by a predetermined value of the reset signal, to provide a output binary value and a feedback binary value of LOW, independently of the value of the input binary data signal value of the clock signal.

In another embodiment, the corrigible comparator is additionally configured as part of a scan flip-flop, i.e. a multiplexed input master-slave based D-flip flop additionally configured to receive, as auxiliary binary input signals a scan-in and a scan-enable signal, thus enabling to perform a so called scan chain on the corrigible comparator. Scan chain is known as a technique used in design for testing devices. The objective is to make testing easier by providing a simple way to set and observe every flip-flop in a circuit. The basic structure of scan chain includes the following set of binary input signals in order to control and observe the scan mechanism. The scan-in signal defines the input of a scan chain. The output value when scan-in is used as input is referred to scan-out. When a scan-enable signal is asserted, all the flip-flops in the design are connected forming a common shift register.

In an embodiment, the auxiliary binary input signals are provided to the comparator stage or the data forwarding stage. In an alternative embodiment, the auxiliary binary input signals are provided to the comparison stage.

In a particular embodiment, the data-forwarding stage comprises an edged-triggered flip-flop. In this embodiment, the forwarding trigger event corresponds to a predetermined clock signal variation between a first and a second clock signal level. In an embodiment, the edge-triggered flip-flop is a positive-edge-triggered flip-flop, wherein the forwarding trigger events are transitions of the clock signal from a LOW or "0" level to a HIGH or "1" level. In an alternative embodiment, the edge-triggered flip-flop is a negative-edge-triggered flip-flop, wherein the forwarding trigger events are transitions of the clock signal from a HIGH or "1" level to a LOW or "0" level. In a particular embodiment, the edge-triggered flip flop is a true single-phase clock edge-triggered flip-flop.

In an alternative embodiment, the data-forwarding stage comprises a level-triggered latch, In this embodiment the forwarding trigger event corresponds to an occurrence of a predetermined clock level signal. In an embodiment, the level-triggered latch is a low-level-triggered latch, wherein the forwarding trigger events are occurrences of a LOW or "0" level of the clock signal. In an alternative embodiment, the level-triggered latch is a high-level-triggered latch, wherein the forwarding trigger events are occurrences of a HIGH or "1" level of the clock signal. In a particular embodiment, the level-triggered latch is a true single-phase clock level-triggered latch.

In another embodiment, the corrigible comparator is part of a master-slave D flip-flop, comprising a master latch and a slave latch wherein the slave latch comprises the comparison stage and the correction stage.

In another embodiment, the correction stage comprises a three input C-element, having as inputs the two external feedback binary values and both the clock signal and an inverse clock signal, wherein the inverse clock signal has the complementary clock signal levels of the clock signal levels of the clock signal. The three input C-element is also referred to as three input guard gate. In an embodiment, the three input C-element comprises three MOS transistors of a first polarity, for instance p-MOS transistors, or alternatively n-MOS transistors, together arranged and configured to control a connection of an output node of the three input C-element to a first supply voltage line, for example VCC, which is associated to a HIGH or "1" binary value, or alternatively GND, which is associated to a LOW or "0" binary value. The two external feedback binary values and the clock signal are provided to a respective one of the gates of the three MOS transistors of the first polarity. In addition, the three input C-element also comprises three MOS transistors of a second polarity, different than the first polarity. These three MOS transistors are together arranged and configured to control a connection of an output node of the three input C-element to a second supply voltage line, different than the first supply voltage line. The two external feedback binary values and the inverse or complementary clock signal are provided to a respective one of the gates of the three MOS transistors of the second polarity. Thus, for establishing an electrical connection between the output node of the three input C-element and either one of the first or the second supply voltage line it is necessary, but not sufficient, that the two external feedback binary values are equal. The other necessary condition for establishing said electrical connection is that the current binary value of the clock signal or of the complementary of the clock signal also cause the corresponding transistor to conduct. Since the clock signal and the complementary of the clock signal are connected to transistors of different polarities, e.g., to a p-MOS transistor and to an n-MOS transistor respectively, they will conduct at the same time. If the clock signal is provided to a p-MOS transistor and the complementary or inverse clock signal is provided to an n-MOS transistor, both the n-MOS and the p-MOS transistors conduct when the clock signal is LOW, which also means that the complementary of the clock signal is HIGH. Thus, the provision of the corrected binary value by the correction stage takes place during the occurrence of a LOW clock phase, which is in this exemplary embodiment the correction trigger event, and in the case wherein the two external feedback binary values have the same value.

Different embodiments have n-MOS transistors as transistors of the first polarity and p-MOS transistors as transistors of the second polarity. Additionally or alternatively, the first supply voltage line is associated to a LOW binary value and the second supply voltage line is associated to a HIGH binary value. Also alternatively or additionally, the clock signal is provided to the gate of an n-MOS transistor and the inverse or complementary clock signal is provided to the gate of a p-MOS transistor. In this particular case, the correction trigger event is the occurrence of a HIGH clock phase.

In an alternative embodiment, the correction stage comprises a two input C-element having as inputs the two external feedback binary values and configured to provide the corrected binary value when the two external feedback binary values have the same binary value. The correction stage also comprises a switching element that is configured to receive the clock signal and to provide, during occurrence of the correction trigger event, the corrected binary value to the comparison stage input interface.

For instance, the two input C-element comprises two MOS transistors of a first polarity, such as p-MOS transistors, or alternatively n-MOS transistors, together arranged and configured to control a connection of an output node of the two input C-element to the first supply voltage line. The two external feedback binary values are provided to a respective one of the gates of the two MOS transistors of the first polarity. In addition, the two input C-element also comprises two MOS transistors of a second polarity, different than the first polarity. These two MOS transistors are together arranged and configured to control a connection of an output node of the two input C-element to a second supply voltage line, different than the first supply voltage line. The two external feedback binary values are also provided to a respective one of the gates of the two MOS transistors of the second polarity. Thus, for establishing an electrical connection between the output node of the two input C-element and either one of the first or the second supply voltage line it is necessary and sufficient, that the two external feedback binary values are equal.

The switching element is, in a particular embodiment a single MOS transistor that is controlled by the clock signal. Depending on the polarity of the MOS transistor the corrected binary value is provided to the comparison stage input interface during a LOW or a HIGH clock phase. In another embodiment, the switching element is a transmission gate that comprises a n-MOS and a p-MOS transistors controlled by one of the clock signal or the inverse clock signal respectively.

In an embodiment, which may include any of the technical features described above with respect to the different embodiments, the comparison stage is a two input C-element. The two input C-element comprises a first and a second MOS transistor, both of a first polarity, either n-MOS or p-MOS, and together arranged and configured to control a connection of the output data interface to the first supply voltage line. The first and second MOS transistor are configured to receive, at their gates, the first and the second comparison binary values respectively. The two input C-element also comprises a third and a fourth MOS transistor, both of a second polarity opposite to the first polarity, and together arranged and configured to control a connection of the output data interface to the second supply voltage line. The third and the fourth MOS transistor are configured to receive at their gates the second and the first comparison binary value respectively.

In the two input C-element a connection of the feedback output interface to the first and the second supply voltage line is controlled by the first and the fourth MOS transistors respectively.

A second aspect of the present invention is formed by a self-correcting triple modular redundancy (TMR) cell which comprises three corrigible comparators in accordance with the first aspect of the invention.

In the self-correcting TMR cell, the comparison stage of a given corrigible comparator is connected to the data-forwarding stage of the same comparator and to the data-forwarding stage of one of the remaining two comparators, for receiving its respective first comparison binary value as the second comparison binary value. In this manner, each of the three comparison stages is connected to a respective different pair of data-forwarding stages.

In the self-correcting triple modular redundancy cell of the second aspect, the correction stage of a given comparator is configured to receive, as the two feedback binary values, the feedback binary values generated and provided by the comparison stages of the remaining two comparators.

In the self-correcting triple modular redundancy cell, the data-forwarding stages of the three corrigible comparators receive a respective input binary data signal. In an embodiment, the three data-forwarding stages are connected such that each receives the same input binary data signal. In an alternative embodiment, each data-forwarding stage receives a respective input binary data signal provided by a respective dedicated logic.

The self-correcting TMR cell of the second aspect thus comprises three corrigible comparators, each receiving a respective input binary data signal. In an error-free operation, each of the three data-forwarding stages output the first comparison binary value which is correlated in an identical way to the current value of the input binary data signal. Therefore, during the occurrence of the clock-based forwarding trigger event, the three first comparison binary values are identical. Since the comparison stages compare different pairs of the three first comparison binary values, and these have an identical binary value in an error-free operation, the three output binary values will also have identical binary values. The same happens with the three feedback binary values, which also have identical binary values. A given correction stage thus receives, as the external feedback binary values the feedback binary values provided by the other two corrigible comparators. In the error-free operation, the provided corrected binary value provided during the occurrence of the clock-based correction trigger event is identical to the first comparison binary value.

However, if an error occurs, for instance due to a single event upset in one of the three corrigible comparators, the self-correcting TMR cell is advantageously configured to identify and correct the error to ensure that the output binary value of the TMR cell is correlated univocally to the value of the input binary data signal at the time of the immediately previous forwarding triggering event.

If for any reason, the data-forwarding stage is affected in such a way that the first comparison value does not correspond to the expected correlation to the binary value of the input binary data, that first comparison binary value will be different than those provided by the remaining two, unaffected, data-forwarding stages. At the comparator stages, both the one receiving the erroneous value as the first comparison binary as well as the one receiving the erroneous value as the external second comparison stage will not provide a significant output binary value, because the first and the second comparison binary values do not have the same binary value. Only that comparison stage receiving the two correct comparison binary values as the first and the second binary values will provide a significant output binary value. In this way, the correctness of the output binary value is guaranteed in the case of a single error in the TMR cell.

The correction function of the TMR cell is implemented in the following way. One corrigible comparator has a data-forwarding stage that has been subject of an error and is therefore providing an erroneous first comparison binary value during the occurrence of the forwarding trigger event. The other two corrigible comparators of the TMR cell have data-forwarding stages that are providing first comparison binary values that are correct. The comparator stages of those two corrigible comparators provide feedback binary values that are correlated to the respective correct first binary value and are therefore identical. These two identical feedback binary values are provided to the correction stage of the corrigible comparator that has been subject to the error. Since both feedback binary values are identical, the corrected binary value is provided to the comparison stage input interface during the occurrence of the correction trigger event, thereby correcting the erroneous value provided by the data-forwarding stage. The other two correction stages receive a correct and an erroneous value at their respective correction stages and therefore do not provide any corrected binary value to the comparison stage input interface of their respective comparison stages.

In any case, whenever there is a first comparison binary value that differs from the other two, the TMR cell is advantageously configured to correct that first comparison binary value by providing, as the corrected binary value, the complementary binary value of the uncorrected first comparison value.

Whenever there is a first comparison binary value that differs from the other two, the TMR cell is advantageously configured to correct that first comparison binary value by providing, as the corrected binary value, the complementary binary value of the uncorrected first comparison value.

The self-correcting TMR cell of the second aspect allows for self-correction of erroneous data in the data-forwarding stages and supports a clock-gating approach while maintain functional correctness. Moreover, the self-correcting TMR cell allows for tolerance to single transient events in normal and clock-gated mode.

In the following, different embodiments of the TMR cell of the second aspect will be described.

The actual way in which the input and output binary values are correlated depend on the implementation of the different embodiments. In an embodiment, the first comparison binary data is correlated to the current binary value of the input binary data signal such that their binary values coincide. Alternatively, the correlation is such that the first comparison binary is the complementary of the current binary value of the input binary data signal.

Also, in an embodiment, the output binary value is correlated to the first comparison binary value such that they have the same binary value. Alternatively, the correlation between the first comparison binary value and the output binary value is such that the output binary value is the complementary of the first comparison binary value. In the same way, the feedback binary value provided by the comparison stage is, in an embodiment, identical to the first comparison binary value and in an alternative embodiment is the complementary binary value.

In a particular embodiment, the three corrigible comparators are configured to receive clock signals with different phases, so that the transitions from a first clock signal level to a second clock signal level occur at different times for each corrigible comparator. Particularly, in an embodiment each of the three corrigible true single-phase clock comparators is configured to receive a respective clock-signal that is phase-shifted with respect to the other two clock signals. Such differences go beyond negligible time differences caused by differences in the length of the electrical lines feeding the clock-signals to the three corrigible comparators.

In an alternative embodiment, the three corrigible comparators are configured to receive a common clock signal.

In another embodiment wherein the three corrigible comparators are configured to receive a common clock signal, the self-correcting triple modular redundancy cell further comprises a single event transient filter unit connected to the data forwarding stages. Single event transients (SET), also referred to as analogue single event upsets (ASEU) are caused by the generation of charge by a single particle, such as a proton or a heavy ion, passing through a sensitive node in an electrical circuit. The SET consists of a transient voltage pulse generated at that node that propagates to the device output.

In a particular embodiment, the single event transient filter unit comprises a data-input delay unit that is connected to at least two of the data-forwarding stages of the three corrigible comparators and configured to delay the input binary data signal, so that variations of the value of the input binary data signal reach the three data-forwarding stages at different times.

In a particularly simple embodiment a first delay unit for providing an output signal correlated to an input signal after a predetermined first delay time is connected to the data input of one of the corrigible comparator and a second delay unit for providing an output signal after a predetermined second delay time is connected to the data input of another one of the corrigible comparators. Thus, variations of the value of the input binary data signal are received at the data input interfaces at different times.

In an alternative embodiment, the single event transient filter unit comprises at least one two-input guard gate configured to receive at its input the input binary data signal and a delayed input binary data signal.

The embodiments where either the input binary data signal or the clock signal is received at the TSPC comparators at different points in time are particularly robust against single event transients.

In another embodiment, the triple modular redundancy cell further comprises a driving stage that is connected to the data output interfaces of the comparison stages of the three corrigible comparators. The driving stage is configured to provide a binary value corresponding to the complementary value of that output binary value provided at least twice by the three corrigible comparators. The driving stage is preferably an inverter, and most preferably comprises two MOS transistors of different polarities and with connected gates, wherein the n-MOS transistor controls a connection of the output node of the inverter to that supply voltage line associated to LOW and the p-MOS transistor controls a connection of the output node of the inverter to that supply voltage line associated to HIGH.

According to a third aspect of the present invention, a method for operating a corrigible true single-phase clock comparator is disclosed. The method comprises:
- receiving a clock signal;
- receiving an input binary data signal. The input binary data signal is indicative of input binary data having, at any given moment, an input binary data value among two possible binary values, referred to herewithin as HIGH or "1" and LOW or "0".
- generating and providing, during occurrence of a clock-based forwarding trigger event in the received clock signal, a first comparison binary value that is correlated to the value of the input binary data;
- receiving the first comparison binary value and an external second comparison binary value for comparing to the first comparison binary value;
- providing an output binary value that is correlated to the first and the second comparison binary value when they have an identical binary value;
- providing, a feedback binary value correlated to the first comparison binary value;
- receiving two external feedback binary values; and
- providing, during occurrence in the received clock signal of a clock-based correction trigger event different from the forwarding trigger event, as a corrected first comparison binary value, a corrected binary value correlated to the two external feedback binary values when they have the same binary value.

The method of the third aspect thus shares the advantages of the corrigible comparator of the first aspect of the invention.

It shall be understood that the corrigible comparator of claim 1, the self-correcting TMR cell of claim 8, and the method for operating a corrigible comparator of claim 13, have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

In the following drawings:
Fig. 1A shows a schematic diagram of a known triple modular redundancy (TMR) cell with a majority voter.
Fig. 1B shows a schematic circuit diagram of a known majority voter.
Fig. 2 shows a schematic block diagram of an embodiment of a corrigible comparator.
Fig. 3 shows a schematic circuit diagram of another embodiment of a corrigible comparator.
Fig. 4A shows a schematic circuit diagram of another embodiment of a corrigible TSCP comparator.
Fig. 4B shows a schematic circuit diagram of an embodiment of a corrigible comparator implemented in a master-slave latch configuration.
Fig. 5A shows a schematic circuit diagram of another embodiment of a corrigible TSCP comparator.
Fig. 5B shows a schematic circuit diagram of another embodiment of a corrigible comparator implemented in a master-slave latch configuration.
Fig. 6 shows a schematic block diagram of an embodiment of a self-correcting triple modular redundancy (TMR) cell.
Fig. 7A shows a schematic block diagram of another embodiment of a self-correcting triple modular redundancy (TMR) cell including three corrigible TSCP comparators.
Fig. 7B shows an example of a clock signal C and the inverse or complementary clock signal C*.
Fig. 8A shows a schematic block diagram of a portion of an embodiment of a self-correcting TMR cell including a single event transient filter unit.
Fig. 8B shows a schematic block diagram of a particular single event transient filter unit including a data-input delay unit.
Fig. 8C shows a schematic block diagram of an alternative single event transient filter unit
Fig. 9 shows a flow diagram of an embodiment of a method for operating a corrigible clock comparator.

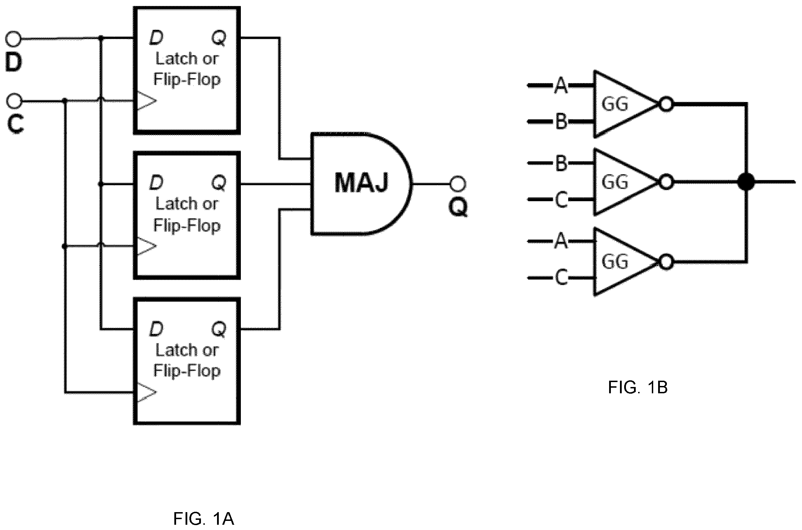

Fig. 1A shows a schematic diagram of a known triple modular redundancy (TMR) cell. The TMR cell includes a triplication of sequential state elements, in this case latches or flip-flops, connected to a majority voter. Typically, the majority voter comprises combinatorial logic gates such as inverter, NOR/NAND, NOR/OR and multiplexers. A custom implementation is based in the usage of guard gates, also referred to as C-elements or two input transition AND gates. A schematic diagram of a known majority voter is shown in Fig. 1B and uses three guard gates GG each connected to a different pair of outputs AB, BC and CA of the three sequential state elements of Fig. 1A. The majority voter of Fig. 1B has an inverting output. An inverter can be added to the output to generate and provide a non-inverted output. Whenever the two inputs of a given GG have an identical binary value, the output of that GG is the complementary binary value of the inputs. If, on the other hand, the two inputs differ, the output of that GG will not be driven by the GG. Therefore, if one of the inputs A, B or C is invalid or erroneous, only the GG that receives the two identical input value will drive the output node.

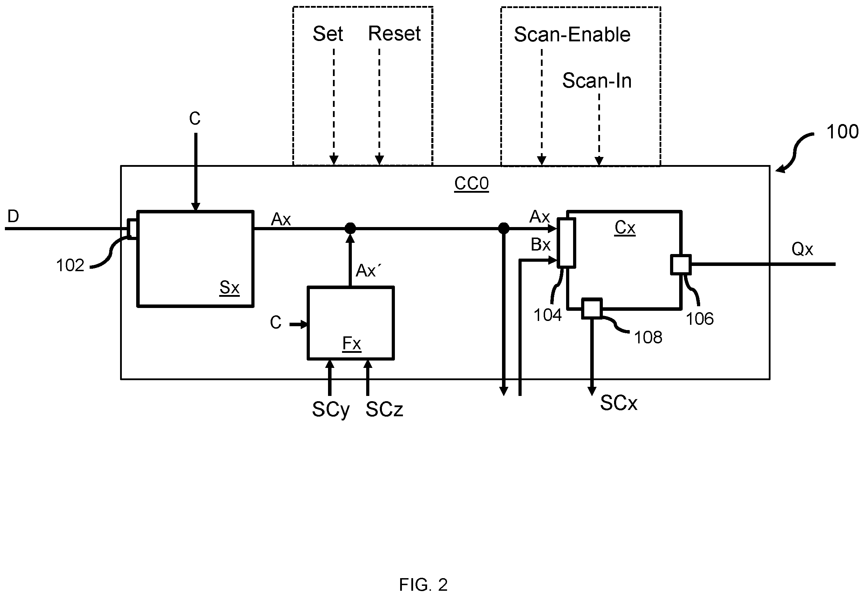

Fig. 2 shows a schematic block diagram of a corrigible comparator 100, also referred to as CC0. The corrigible comparator 100 comprises a data-forwarding stage Sx, which is configured to receive an input binary data signal D and a clock signal C. The data-forwarding stage Sx is configured to generate and provide, during occurrence of a clock-based forwarding trigger event in the received clock signal C, a first comparison binary value Ax that is correlated to the current binary value of input binary data signal D. For example, the data-forwarding stage is an inverting stage wherein the first comparison binary value is the inverse of the value of the input binary data signal during occurrence of the forwarding trigger event. Alternatively, the data-forwarding state is a non-inverting stage wherein the first comparison binary value corresponds to the value of the input binary data signal during occurrence of the forwarding trigger event.

In a particular corrigible comparator, the data-forwarding includes a level-triggered latch, which can be either a high-level triggered latch or a low-level triggered latch, which can be, in a particular variant, a true single-phase clock (TSPC) latch. In the former, the forwarding event is the occurrence of a high level in the clock signal, and in the latter, the forwarding event is the occurrence of a low level in the clock signal.

In another corrigible comparator, the data-forwarding includes an edge-triggered flip-flop, which can be either a positive-edge triggered flip-flop or a negative-edge triggered flip-flop, also optionally true single-phase clock flip-flops. In the former, the forwarding event is the occurrence of a transition from a low level to a high level in the clock signal, and in the latter, the forwarding event is the occurrence of a transition from a high level to a low level in the clock signal.

The corrigible comparator 100 also includes a comparison stage Cx that is configured to receive at a comparison stage input interface 104 the first comparison binary value Ax and an external second comparison binary value Bx for comparing to the first comparison binary value. When the first and the second comparison binary values are identical, i.e., either both HIGH or "1", or both LOW or "0", the comparison stage is configured to provide, via an output data interface 106 an output binary value Qx that is correlated to the first comparison binary value Ax. As in the case of the data-forwarding stage, the comparison stage is in a particular corrigible comparator an inverting stage where the output binary value is the complementary value of the first and the second comparison binary value. In another corrigible comparator, the comparison stage is a non-inverting stage, where the output binary value corresponds to the value of the first and the second comparison binary data.

In addition, the comparison stage is also configured to provide, via a feedback output interface 108, a feedback binary value SCx that is correlated to the first comparison binary value Ax. Here again, the correlation between the feedback binary value and the first comparison binary value is, in a particular comparison stage, a direct correspondence where the binary values coincide, and in an alternative comparison stage, a correlation where the feedback binary value is the inverse of the first comparison binary value.

The corrigible comparator also includes a correction stage Fx for performing a correction function. The correction stage is configured to receive two external feedback binary values SCy, SCz and the clock signal C. When the two external feedback binary values have the same binary value and during an occurrence in the received clock signal of a clock-based correction trigger event different from the forwarding trigger event, the correction stage is configured to provide, to the comparison stage input interface, a corrected binary value Ax' correlated to the two external feedback binary values SCy, SCz. Here again, the correlation between the two external feedback binary values and the corrected binary value is, in a particular correction stage, a direct correspondence where the binary values coincide, and in an alternative correction stage, a correlation where the corrected binary value is the inverse or the complementary of both external feedback binary values.

Optionally, as indicated by the discontinued arrows, the corrigible comparator is additionally configured to receive auxiliary binary input signals such as an asynchronous "set" and/or "reset" signal or a "Scan-In" and a "Scan-Enable". In the case of receiving a "set" and/or a "reset" signal as auxiliary binary asynchronous input signals, the particular comparator is configured, if indicated by a predetermined value (e.g. HIGH) of the set signal, to provide a output binary value Qx and preferably also a feedback binary value Scx of HIGH or "1", independently of the value of the input binary data signal value D of the clock signal C. Additionally, or alternatively, the comparator is configured, if indicated by a predetermined value of the reset signal (e.g. HIGH), to provide a output binary value Qx, and preferably also a feedback binary value Scx of LOW or "0", independently of the value of the input binary data signal value D of the clock signal C. In the case of receiving a "Scan-In" and a "Scan-Enable" signal as auxiliary binary input signals, the corrigible comparator is advantageously configured to perform a scan function, or scan chain, for example when multiple flip flops are connected. The scan-enable signals puts all the flip flops in a scan mode, wherein a scan- in signal is fed to the circuit for testing.

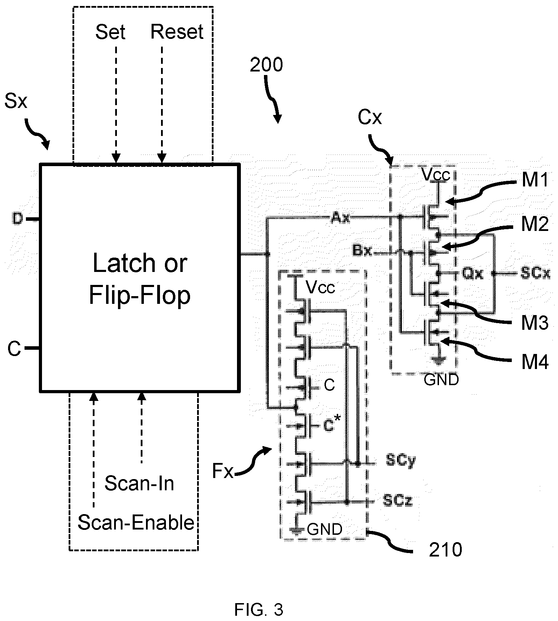

Fig. 3 shows a schematic circuit diagram of an exemplary corrigible TSCP comparator 200, wherein the data-forwarding stage is a sequential element, such as a flip-flop or a latch that receives the input binary data D, and the clock signal C and outputs the first comparison value Ax.

In the corrigible comparator 200 of Fig. 3, the comparison stage Cx is a two input C-element that comprises a first M1 and a second M2 MOS transistor, both p-MOS transistors, and together configured to control a connection of the output data interface Qx to a first supply voltage line Vcc, associated to the binary value "1" or HIGH. The first and second MOS transistor are arranged and configured to receive at their gates the first comparison binary value Ax and the external second comparison binary value Bx respectively.

The two input C-element also comprises a third M3 and a fourth M4 MOS transistor, both n-MOS transistors, and together configured to control a connection of the output data interface Qx to a second supply voltage line GND, associated to the binary value "0" or LOW. The third and the fourth MOS transistor are configured to receive at their gates the second Bx and the first comparison binary value Ax respectively.

Therefore, the value at the output data interface, which is the node labelled as Qx in Fig. 3 is the inverse of both the first and the second comparison binary value, when the two values coincide. In case the first and the second comparison binary value do not coincide, the output node is not connected to neither the first nor the second supply voltage line GND, Vcc.

Additionally, the nodes between M1 and M2 and between M3 and M4 are the feedback output interfaces, where a feedback binary value corresponding to the inverse of the first comparison binary value is always provided. In fact, regardless of the current value the first comparison binary value, either p-MOS transistor M1 or n-MOS transistor M4 will conduct and the feedback output node will be connected to either VCC when Ax=0 or to GND when Ax=1. Therefore, a connection of the feedback output interface SCx to the first Vcc and the second GND supply voltage line is controlled by the first M1 and the fourth M4 MOS transistors respectively.

The corrigible comparator also comprises a correction stage Fx, which, in this particular example comprises a three input C-element 210. The three input C-element 210 has, as inputs, the two external feedback binary values SCy, SCz and both the clock signal C and an inverse clock signal C*, wherein the inverse clock signal has the complementary clock signal levels of the clock signal levels of the clock signal. During an occurrence in the received clock signal C of a clock-based correction trigger event different from the forwarding trigger event, the correction stage Fx of Fig. 3 is to provide to the comparison stage input interface, as a corrected first comparison binary value, a corrected binary value correlated to the two external feedback binary values SCy, SCz when the two external feedback binary values have the same binary value. In the correction stage Fx of Fig. 3, the output node of the three input C-element 210 is electrically connected to the GND voltage supply line when Scx and Scy are "1" and the value of inverted clock signal is HIGH, i.e. the value of the clock signal is LOW. Accordingly, the output node of the three input C-element 210 is electrically connected to the Vcc voltage supply line when Scx and Scy are "0" and the value of the clock signal is LOW. Therefore, the corrected binary value is provided whenever Scx and Scy have the same value and the clock signal is LOW, being this the correction trigger event that is different from the forwarding trigger event.

Optionally, as shown by the dashed lines, the latch or flip-flop Sx of the corrigible comparator 200 may additionally receive auxiliary binary input signals such as an asynchronous set and/or an asynchronous reset signal or additional input signals such as scan-in and scan-enable signals, or both set/reset and scan-in/scan-enable signals.

In alternative comparators, the three input C-element is arranged so that the correction trigger event is the occurrence of a HIGH level in the clock signal. Additionally or alternatively, the provided corrected binary value is the same as the two external feedback binary values.

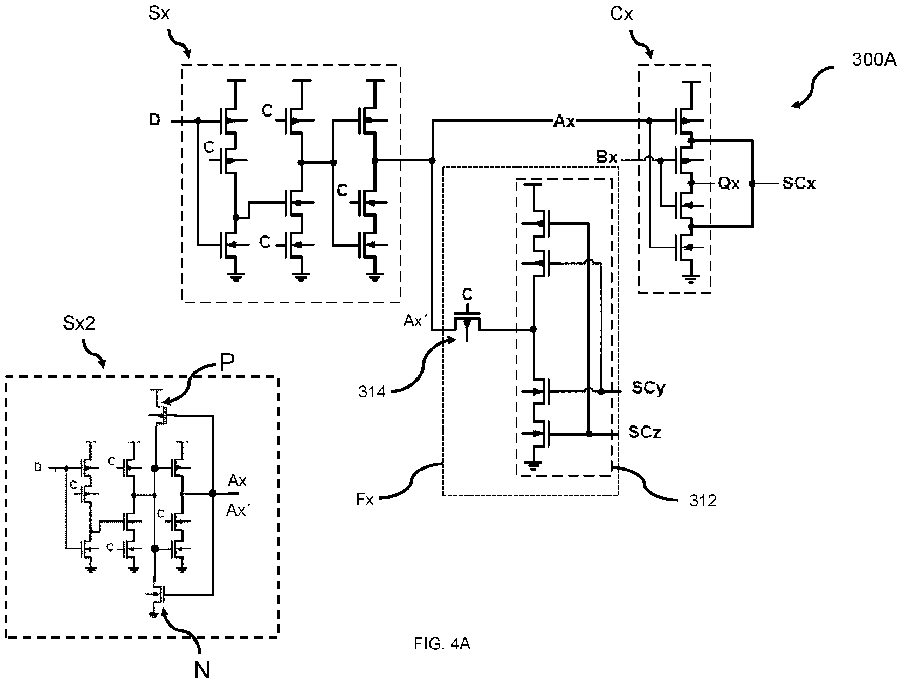

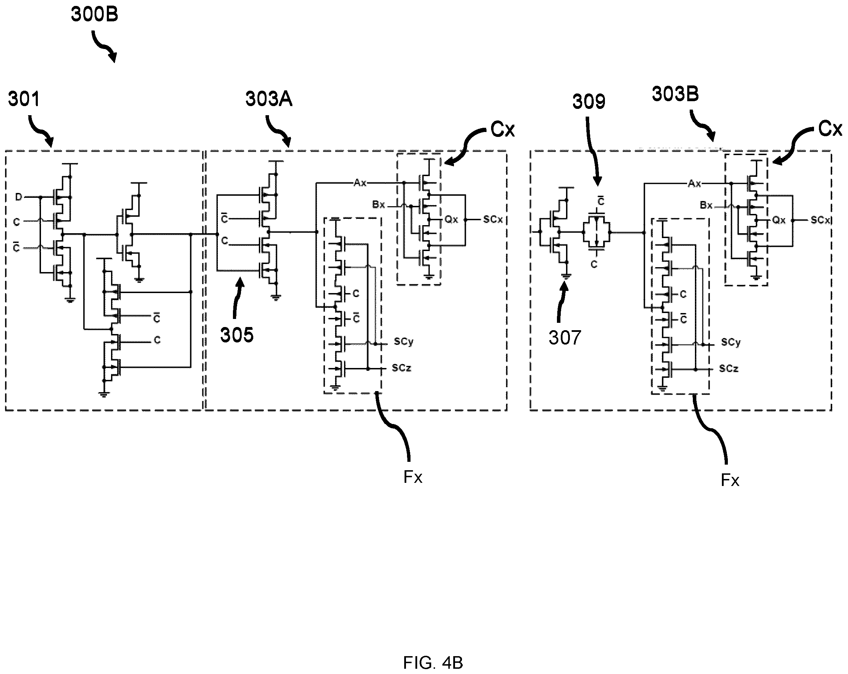

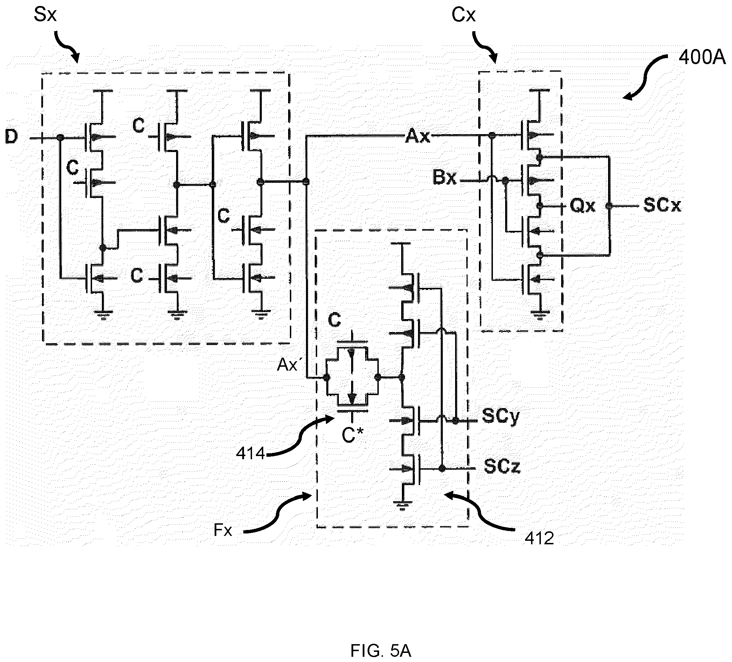

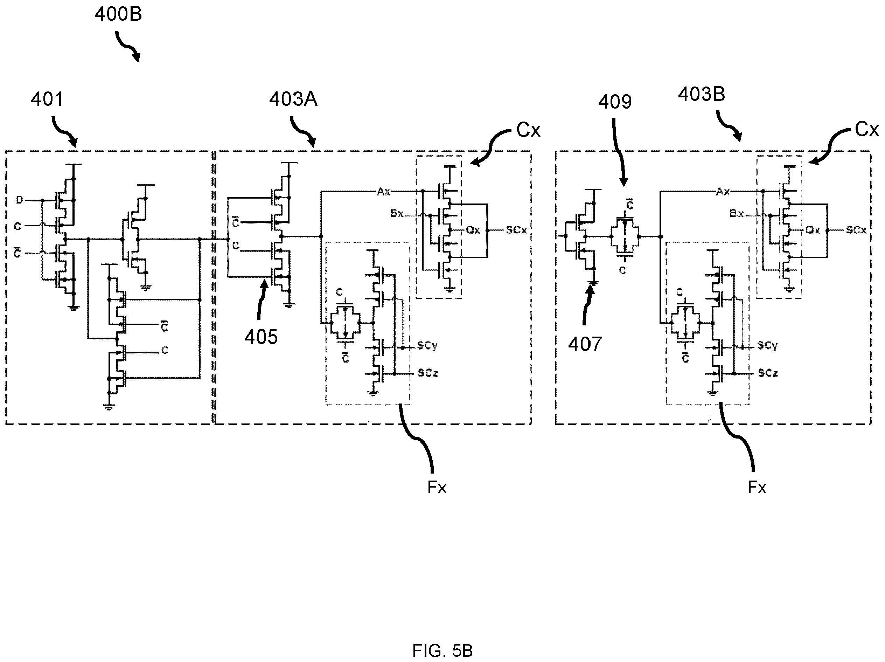

Figs. 4A, 4B and 5A, 5B show schematic circuit diagrams of corrigible comparators 300A, 300B and 400A, 400B respectively. The corrigible comparators 300A and 400A of Figs. 4A and 5A respectively are corrigible true single-phase clock (TSPC) comparators, wherein the data-forwarding stage Sx is a positive-edge triggered TSPC flip-flop with an inverting output. The input binary data signal is provided to a first stage of the data-forwarding stage, that also receives the clock signal. The output of this first stage is "0" whenever D is "1", irrespectively of the current value of the clock signal, since the output node of the first stage is electrically connected to the GND voltage supply line via the n-MOS transistor. Conversely, the output of this first stage is "1" whenever the clock signal is LOW and D is "0" since the output node of the first stage is electrically connected to the VCC voltage supply line via the two p-MOS transistors. If D is "0" and the clock signal is HIGH, the output node is neither connected to GND nor to VCC because the n-MOS transistor and the p-MOS transistor receiving the clock signal at its gate do not conduct. The data-forwarding stage Sx of Figs. 4A and 5A also comprise a second stage that receives as input the output value of the first stage and the clock signal. The output of the second stage is "1" whenever the clock signal is "0" and "0" whenever the clock signal and the input, i.e. the output of the first stage, are both "1" or HIGH. The data-forwarding stage Sx further comprises a third stage that is analogous to the first stage in the sense that the clock is fed to only one transistor, in this case a n-MOS whereas the output of the second stage is provided to two transistors of different polarities, i.e. a p-MOS and an n-MOS transistor. The third stage is configured to output the first comparison binary value as a function of the output of the second stage and the clock signal. When analysing the three stages of the data-forwarding stage, the first comparison binary value is the inverse of the value of the input binary data signal at the occurrence of a transition from a LOW level of the clock signal to a HIGH level of the clock signal, which is the forwarding trigger event of this particular TSPC comparator. The value of the first comparison binary value remains at that level until, during the occurrence of a next forwarding event, where, depending on whether the value of the input binary data signal has changed or not, the provided first comparison value will be updated or hold.

Fig. 4A also shows another possible implementation of the data-forwarding stage Sx2, which is suitable for exchange with data-forwarding stage Sx. The data-forwarding stage comprises a feedback loop comprising a p-MOS transistor P and an n-MOS transistor N controlling a connection of the first voltage supply line VCC and the second voltage supply line GND with the input of the third stage of the data-forwarding stage respectively. The p-MOS and the n-MOS transistors receive at their gates the first binary comparison value Ax and the corrected binary value AX'. This configuration is particularly advantageous in the case of using gated clock signals for correction of internal nodes. The data-forwarding stages Sx and Sx2 can be also used with other configurations of the feedback stage Fx, as described with respect to other figures.

The integration of the first half of the guard gate/C-element-based voter logic inside of the feedback is realized with an additional Guard Gate / C-element what provides both the internal stored value SCx, generated by the outer MOS transistors and needed for the other two flops to be corrected, and the node Qx that constitutes the majority gate functionality in parallel. As a consequence, two functions are realized at the same time - the always present inversion of the internal feedback SCx, and a pre-voted output.

One main advantage of this implementation is, that 3x2 MOS transistors can be saved, due to the integration of the first half of the full voter inside of the last stage of the baseline TSCP flip-flop. Moreover, due to the integration, the same gates constituting the voter, generate the inversion SCx for the feedback in parallel. Consequently, the overhead of TMR-voter is neither 12 or 14 MOS transistors when selecting the GG-based voter solution. Using this approach, the overhead is only determined by eight less MOS transistors compared to common GG-based voter, when connected to common TSPC baseline flip-flops. Moreover, the propagation delay of the full TMR flip-flop is reduced by two inverter delays due to the integration.

In alternative TSPC comparators, the edge triggered flip-flop is a negative-edge triggered flip-flop where the polarities of the MOS transistors are inverted, so that p-MOS transistors are replaced with n-MOS transistors and vice versa.

In the TSPC comparator 300A, the correction stage Fx comprises a two input C-element 312 that has as inputs the two external feedback binary values SCy, SCz. The two input C-element 312 is arranged configured to provide the corrected binary value Ax' when the two external feedback binary values have the same binary value. In cases where the binary values of the two external feedback binary values differ, the output node of the two input C-element is connected neither to the first not to the second voltage supply line. The correction stage Fx of TSPC comparator 300A also comprises a switching element 314 in the form of a MOS transistor, in particular in Fig. 4A a p-MOS transistor, that is configured to receive the clock signal C and to provide, during occurrence of the correction trigger event, the corrected binary value Ax' to the comparison stage input interface. In this particular correction stage, the correction trigger event is the occurrence of a LOW level of the clock signal. In an alternative correction stage, the switching element is an n-MOS transistor and the correction trigger event is the occurrence of a HIGH level of the clock signal. Alternatively, the correction trigger event can be changed by providing the inverse of the clock signal to the gate of the MOS transistor of the switching element 314.

The corrigible comparator 300B of Fig. 4B comprises a master-latch 301 and a slave-latch, of which two alternative configurations 303A and 303B are shown. In slave latch 303A, the output of the master latch 301 is connected to an input of a guard gate element 305. The output of the guard gate element is the first comparison binary value that is provided to the comparison stage Cx, in this particular example when the clock signal is HIGH. In slave latch 303B, the output of the master latch 301 is connected to an inverter stage 307 which is in turn connected to a transmission gate 309 for providing the first comparison binary value to the comparison stage Cx, in particular in this example, when the clock signal C is HIGH and the inverse clock signal C is LOW. In both slave latches 303A and 303B, the feedback stage provides the corrected value whenever the clock signal is LOW and the values of SCy and SCz are identical.

The correction stage Fx of the TSPC comparator 400A of Fig. 5A also comprises a two input C-element 412 analogous to that of TSPC comparator 300A of Fig. 4A. The correction stage Fx of TSPC comparator 400A includes, as a switching element 414 a transmission gate that is configured to provide the corrected binary value Ax' to the comparison stage input interface whenever the clock signal C has a LOW value or level. The correction trigger event can be easily adapted by either changing the polarity of the MOS transistors or by providing the clock signal to the n-MOS transistor and the inverse clock signal to the p-MOS transistor.

The corrigible comparator 400B of Fig. 5B comprises a master-latch 401 and a slave-latch, of which two alternative configurations 403A and 403B are shown. In slave latch 403A, the output of the master latch 401 is connected to an input of a guard gate element 405. The output of the guard gate element is the first comparison binary value that is provided to the comparison stage Cx, in this particular example when the clock signal is HIGH. In slave latch 403B, the output of the master latch 401 is connected to an inverter stage 407 which is in turn connected to a transmission gate 409 for providing the first comparison binary value to the comparison stage Cx, in particular in this example, when the clock signal C is HIGH and the inverse clock signal C is LOW. In both slave latches 403A and 403B, the feedback stage provides the corrected value whenever the clock signal is LOW and the values of SCy and SCz are identical.

Fault-tolerant systems typically require integrated correction mechanism in order to maintain a specific functionality. Solutions include adding redundant circuit parts, redundancy in time or the usage of error-correcting codes. A majority voter allows for a selection of correct values out of redundant logic parts. Sequential logic elements, i.e., storage elements such as flip-flops or latches hold or capture an input signal value depending on a sensitive phase or edge of a trigger signal. As a consequence, with each new forwarding event, a new data value is hold or captured. In the case of an erroneously held data value, the refreshing by overwriting in performed with the new forward trigger event.

The corrigible comparator 300B of Fig. 4B comprises a master-latch 301 and a slave-latch, of which two alternative configurations 303A and 303B are shown. In slave latch 303A, the output of the master latch 301 is connected to an input of a guard gate element 305. The output of the guard gate element is the first comparison binary value that is provided to the comparison stage Cx, in this particular example when the clock signal is HIGH. In slave latch 303B, the output of the master latch 301 is connected to an inverter stage 307 which is in turn connected to a transmission gate 309 for providing the first comparison binary value to the comparison stage Cx, in particular in this example, when the clock signal C is HIGH and the inverse clock signal C is LOW. In both slave latches 303A and 303B, the feedback stage provides the corrected value whenever the clock signal is LOW and the values of SCy and SCz are identical.

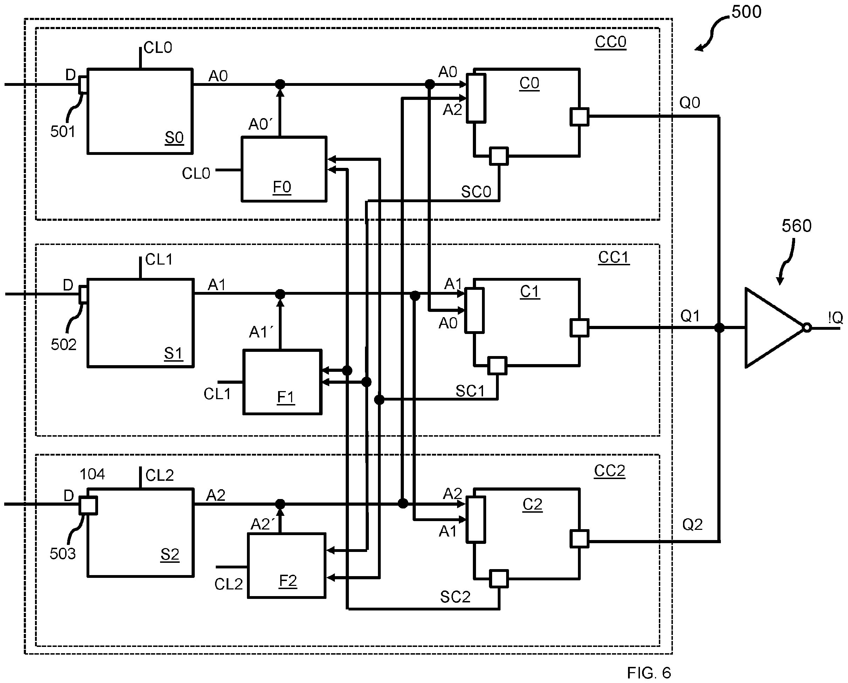

Fig. 6 shows a schematic block diagram of a self-correcting triple modular redundancy (TMR) cell 500 comprising three corrigible comparators CC0, CC1, CC2, each receiving a clock signal CL0, CL1, CL2 that is shifted in time, i.e. having a different phase with respect to the other clock signals. In an alternative self-correcting TMR cell (not shown) all three corrigible comparators receive the same clock signal with the same frequency, phase and duty cycle, within the slight time delays caused by electrical connections of different lengths.

In the self-correction TMR cell 500, the data-forwarding stages S0, S1, S2 of the three corrigible comparators are connected for receiving the input binary data signal D. Further, the comparison stage of a given comparator is connected to the data-forwarding stage of the same comparator and to the data-forwarding stage of one of the remaining two comparators, such that each of the three comparison stages is connected to a respective different pair of data-forwarding stages. For instance, in the TMR cell 500, the comparison stage C0 receives the first comparison binary data from the data-forwarding stage S0 and the external second comparison data from the data-forwarding stage S2 of CC2, the comparison stage C1 receives the first comparison binary data from the data-forwarding stage S1 and the external second comparison data from the data-forwarding stage S0 of CC0 and the comparison stage C2 receives the first comparison binary data from the data-forwarding stage S2 and the external second comparison data from the data-forwarding stage S1 of CC1. In an alternative TMR cell, C0 receives A0 and A1, C1 receives A1 and A2 and C2 receives A2 and A0.

In the self-correcting TMR cell 500, the correction stage of a given corrigible comparator is configured to receive, as the two feedback binary values, the feedback binary values generated and provided by the comparison stages of the remaining two corrigible comparators.

Thus, the F0 receives SC1 and SC2, F1 receives SC0 and SC2 and F2 receives SC0 and SC1.

The TMR cell 500 optionally comprises a driving stage 560 that is connected to the data output interfaces of the comparison stages C0, C1, C2 of the three corrigible comparators CC0, CC1, CC2. The driving stage is configured to provide a binary value Q that corresponds to the complementary value of that output binary value Q0, Q1, Q2 provided at least twice by the three corrigible comparators CC0, CC1, CC2.

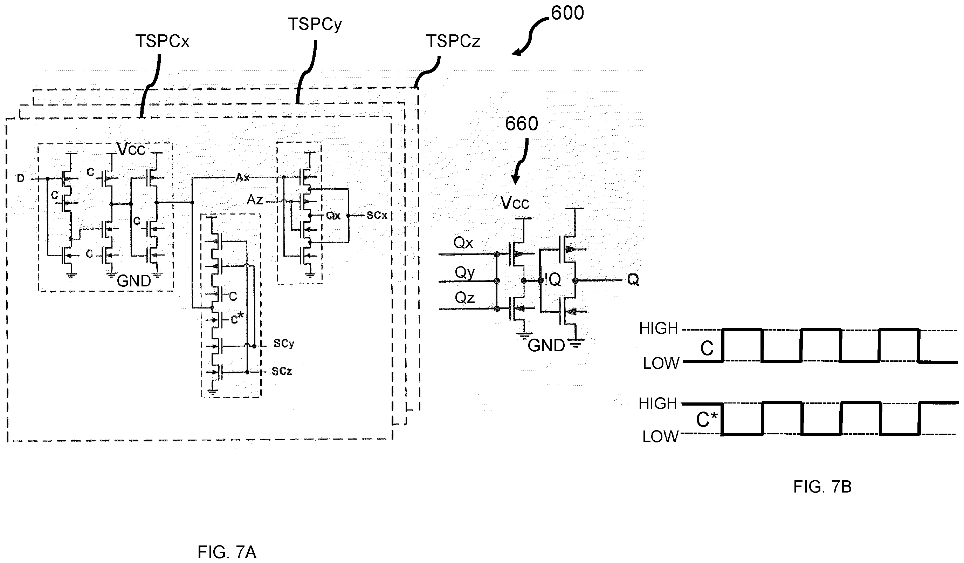

Fig. 7A shows a schematic circuit diagram of a self-correcting TMR cell 600 that exemplarily uses three true single-phase clock (TSPC) comparators TSPCx, TSPCy and TSPCz.. Shown is the circuit of one of the TPSC comparators TSPCx, which receives the input binary data signal D and provides the output binary value Qx and the feedback binary value SCx. The comparison stage of TSPCx receives the external second comparison binary value Az from another TSPC comparator, in this case TSPCz. The other two TSPC comparators TSPCy and TPSCz also receive the input binary data signal D and provide the output binary values Qy, Qz and the feedback binary values SCy, SCz, respectively. They are also arranged to receive their respective external second comparison binary value in accordance with the connections described with respect to the TMR cell 500 of Fig. 6 wherein the sub-indices 0, 1 and 2 of Fig.6 correspond to the sub-indices x, y and z of Fig. 7A . In the TMR cell 600 of Fig. 7A, the three TSPC comparators receive the same clock signal, without any intentional delay. In this particular TMR cell 600, the data-forwarding stages are positive edge triggered flip-flops and the forwarding trigger event is a transition from a LOW level clock signal to a HIGH level clock signal.

Fig. 7B shows an example of a clock signal C and the inverse or complementary clock signal C*. Other clock suitable clock signals having different wave forms, frequency and/or duty cycles. An inverted clock signal can be obtained by inverting the original non-inverted clock signal. Alternatively, two clock signals can be provided and then synchronized to be complementary to each other.

The following table 1 summarizes the behaviour of the TMR cell 600 when there is no error in the data-forwarding stages and the values provided by them, i.e., their respective first comparison binary values Ax, Ay and Az are all univocally correlated in the same manner to the value of the input binary data signal D during the occurrence of the forwarding trigger event.

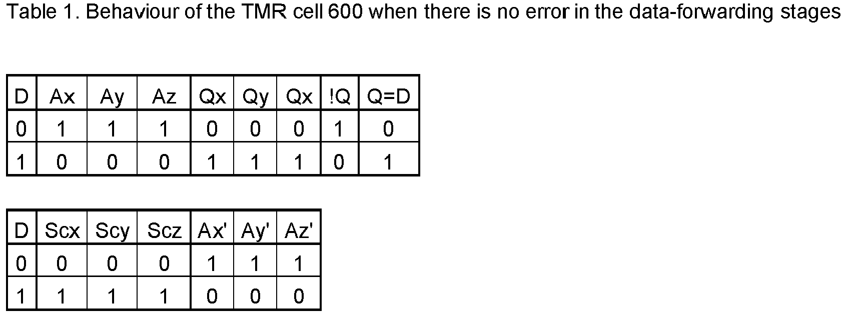

The upper part of the table represents the triple modular redundancy function of the self-correcting TMR cell 600, wherein the lower part of the table represents the self-correcting function.

When the input binary data signal has a given value, such as "0", during the occurrence of the forwarding trigger event, i.e. a positive edge in the clock signal, the first comparison binary values are identical and the complementary of D, i.e., "1". All of the comparison stages receive at their inputs the same binary values "1" and therefore provide the output binary values Qx, Qy, Qz with a value of "0". The driving stage 660 thus provides !Q with a value of "1" which is then inverted to obtain Q with a binary value of "0" that corresponds to the value of D. The same reasoning applies mutatis mutandis for a D value of "1".

The comparison stages also provide the respective feedback binary values Scx, Scy and Scz. This is shown in the lower part of table 1. The feedback binary values are the complementary of the respective first comparison binary data and are provided to the correction stages of the other two TSPC comparators. In the case where there is no error, the corrected binary values are all the complementary of the feedback binary values and thus correspond to the values of the first comparison binary values. The corrected binary values are provided to the comparison stage input interface during a LOW phase of the clock signal, which is referred to as the correction trigger event and is different from the forwarding trigger event. The corrected values provided are equal to the already provided first comparison binary value so no effective correction is done.

The following table 2 summarizes the behaviour of the TMR cell when there is an error in one of the data-forwarding stages, namely in TSPCx.

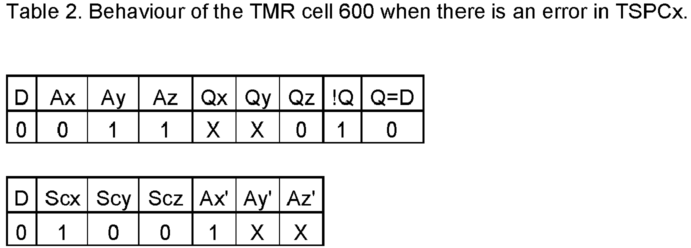

In this case, during operation of the self-correcting TMR cell, an error occurs that causes that the first comparison binary value provided by TSPCx does not follow the expected correlation with respect to the value of the input binary data signal. In this particular example, a correct first comparison binary value has the complementary value of the input binary data signal. TSPCy and TSPCz both provide the right first comparison binary value of "1" when D is "0". TSPCx however outputs a "0". The comparator stages of TSPCx and TSPCy receive both a "0" and a "1" value at their inputs and their output binary value remains undetermined, since no electrical connection is established between their output nodes and either the first or the second supply voltage line. However, the comparator stage of TSPCz receives two identical inputs having the value "1", namely those first comparison binary values provided by TSPCy and TSPCz. The output binary value Qz is the complementary value of Ay and Az, and is therefore "0". Since all three output nodes are connected, only the comparator stage of TPSCz drives the common output node. The inverting stage 660 provided !Q with a value of "1" and the following inverting stage provides the complementary of !Q which is "0" and corresponds to the value of D during occurrence of the forwarding trigger event.

The self-correcting function of the self-correcting TMR cell is explained with reference to the lower part of table 2. The feedback binary values provided by TSPCx, TSPCy and TSPCz are the complementary values of the respective first comparison binary values. Thus, SCx, SCy and SCz are, in the case of D being "0" and an error occurring in the flip-flop of TSPCx, "1", "0" and "0" respectively. The correction stages of TSPCy and TSPCyz both receive, at their inputs, two different feedback binary values. Thus, no corrected binary values are generated because the output node is not connected to either one of the two voltage supply lines. However, TSPCy and TSPCz have not been subject of any error. In the case of the correction stage of TSPCz, it receives the feedback binary values Scy and Scy which are identical and equal to "0". Thus, when the clock signal is LOW, a corrected binary value of "1" will be provided to the comparison stage input interface of the comparison stage of TSPCx, thereby correcting the erroneous value of the first comparison binary value of "0".

The discussion above regarding Tables 1 and 2 is also applicable to the TMR cell 500 of Fig. 6, where the sub-indexes "x", "y" and "z" of the TMR cell 600 of Fig. 7 and Tables 1, and 2 correspond to the sub-indexes "0", "1" and "2".

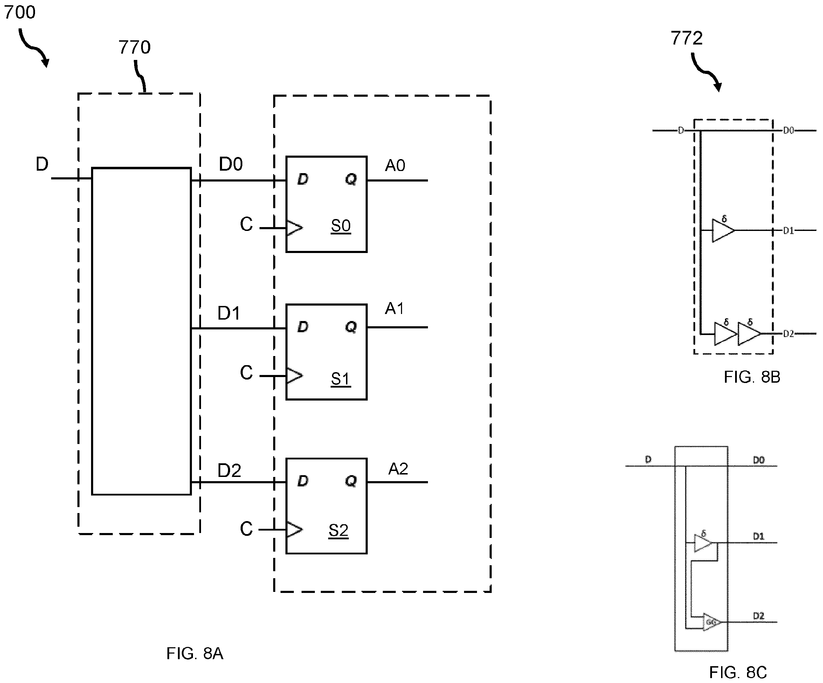

Fig. 8A shows a schematic block diagram of a portion of a self-correcting TMR cell 700 including a single event transient filter unit 770. A particular example of the single event transient filter unit is shown in Fig. 8B. In Fig. 8B, the single event transient filter unit is a data-input delay unit 772 configured to delay an electrical input signal D, so that variations of the value of the input binary data D reach the three data-forwarding stages S0, S1 and S2 at different times, as D0, D1, D2. In Fig. 8B D0 corresponds to the signal D, D1 is delayed using a single delay unit and D2 is delayed using two delay units connected in series. Alternatively only two delay units can be used. The input of the first delay unit is D0, the output of the first delay unit, which corresponds to the input of the second delay unit is D1 and the output of the second delay unit is D2.

An alternative single event transient filter unit is shown in Fig. 8C. The single event transient filter unit comprises of Fig. 6C comprises one two-input guard gate configured to receive at its input the input binary data signal D and a delayed input binary data signal that is generated by a delay unit. The output of the guard gate D2 is provided to one of the three comparators. Another one of the comparator receives the input binary data signal D and the remaining comparator unit receives the delayed input binary data signal D1 Additional combinatorial logic such a guard gate followed by an inverter can also be connected for signal inversion or logical combinations.

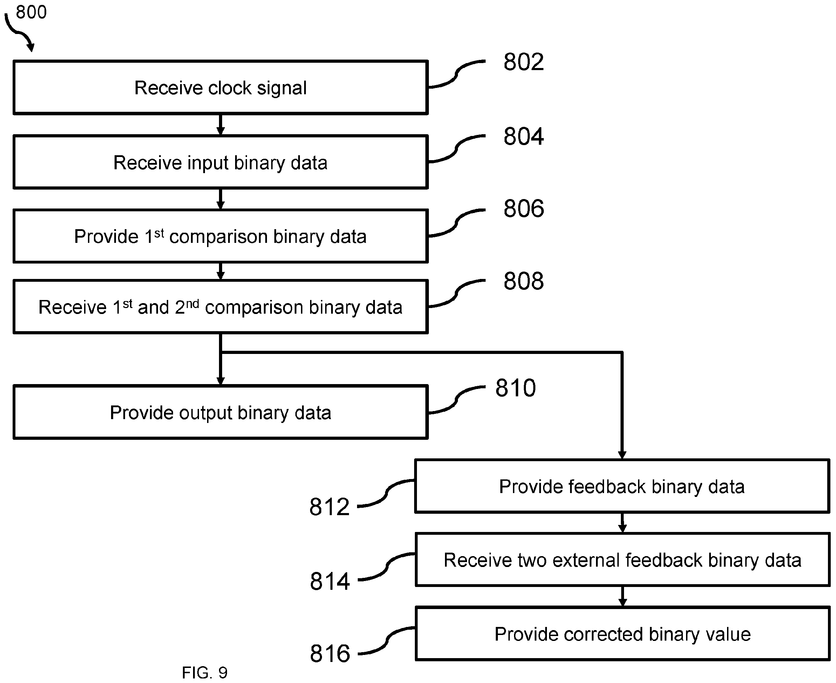

Fig. 9 shows a flow diagram of an exemplary method 800 for operating a corrigible comparator. The method comprises receiving, in a step 802 a clock signal and in a step 804, an input binary data signal. The method also includes, in a step 806 generating and providing, during occurrence of a clock-based forwarding trigger event in the received clock signal, a first comparison binary value that is correlated to the value of the input binary data. The method also comprises, in a step 808, receiving the first comparison binary value and an external second comparison binary value for comparing to the first comparison binary value. In a step 810, the method also comprises providing an output binary value that is correlated to the first and the second comparison binary value when they have an identical binary value. Further, the method also comprises, in a step 812, providing, a feedback binary value correlated to the first comparison binary value, in a step 814, receiving two external feedback binary values, and in a step 816, providing during occurrence in the received clock signal of a clock-based correction trigger event different from the forwarding trigger event, as a corrected first comparison binary value, a corrected binary value correlated to the two external feedback binary values when they have the same binary value.

It shall be understood, that any input or output digital signal can be inverted to obtain its complementary signal by adding an inverter unit, should the inverted signal be favoured.

In summary, the invention is directed to a corrigible comparator. The corrigible comparator comprises a data-forwarding stage configured to provide in dependence on a clock-based forwarding trigger event a first comparison binary value that is correlated to a current binary value of input binary data signal. In a comparison stage, this value is compared to an external second comparison binary value and an output binary value that is correlated to the first comparison binary value is provided when the compared values are identical. A feedback binary value correlated to the first comparison binary value is provided. A correction stage is configured to receive external feedback binary values and, depending on a correction trigger event, to provide to the comparison stage a corrected binary value correlated to the feedback binary values when they have the same binary value.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

A single unit, stage or device may fulfil the functions of several items recited in the claims. The mere fact that certain measures are recited in mutually different dependent claims does not indicate that a combination of these measures cannot be used to advantage.

Any reference signs in the claims should not be construed as limiting the scope.

## Claims

1. A corrigible comparator (100), comprising
- a data-forwarding stage (Sx) configured to receive an input binary data signal (D) and a clock signal (C) and to generate and provide, in dependence on an occurrence of a clock-based forwarding trigger event in the received clock signal (C), a first comparison binary value (Ax) that is correlated to the current binary value of input binary data signal (D);
- a comparison stage (Cx) configured:
- to receive at a comparison stage input interface (104) the first comparison binary value (Ax) and an external second comparison binary value (Bx) for comparing to the first comparison binary value;
- to provide via a feedback output interface (108), a feedback binary value (SCx) correlated to the first comparison binary value (Ax); and
- when the first and the second comparison binary values (Ax, Bx) have an identical binary value, to provide, via an output data interface (106), an output binary value (Qx) that is correlated to the first comparison binary value (Ax); and
- a correction stage (Fx) configured to receive two external feedback binary values (SCy, SCz) and the clock signal (C) and, in dependence on an occurrence in the received clock signal (C) of a clock-based correction trigger event different from the forwarding trigger event, to provide to the comparison stage input interface, as a corrected first comparison binary value, a corrected binary value (Ax') correlated to the two external feedback binary values (SCy, SCz) when the two external feedback binary values have the same binary value.

2. The corrigible comparator of claim 1, wherein the data-forwarding stage comprises an edged-triggered flip-flop; and wherein the forwarding trigger event corresponds to a predetermined clock signal variation between a first and a second clock signal level.

3. The corrigible comparator of claim 1 wherein the data-forwarding stage comprises a level-triggered latch; and wherein the forwarding trigger event corresponds to an occurrence of a predetermined clock level signal.

4. The corrigible comparator (200) of any of the preceding claims, wherein the correction stage (Fx) comprises a three input C-element (210), having as inputs the two external feedback binary values (SCy, SCz) and both the clock signal (C) and an inverse clock signal (C*), wherein the inverse clock signal has the complementary clock signal levels of the clock signal levels of the clock signal.

5. The corrigible comparator (300, 400A, 400B) of any of the claims 1 to 3, wherein the correction stage (Fx) comprises:
- a two input C-element (312, 412) having as inputs the two external feedback binary values (SCy, SCz) and configured to provide the corrected binary value (Ax') when the two external feedback binary values have the same binary value;
- a switching element (314, 414) configured to receive the clock signal and to provide, during occurrence of the correction trigger event, the corrected binary value (Ax') to the comparison stage input interface.

6. The corrigible comparator (300, 400) of claim 5, wherein the switching element of the correction stage (Fx) is a single MOS transistor (314) or a transmission gate (414).

7. The corrigible comparator (200, 300, 400A, 400B) of any of the preceding claims, wherein the comparison stage (Cx) is a two input C-element comprising:
- a first (M1) and a second (M2) MOS transistor, both of a first polarity and together configured to control a connection of the output data interface (Qx) to a first supply voltage line (Vcc); the first and second MOS transistor being configured to receive at their gates the first and the second comparison binary values (Ax, Bx) respectively
- a third (M3) and a fourth (M4) MOS transistor, both of a second polarity opposite to the first polarity, and together configured to control a connection of the output data interface (Qx) to a second supply voltage line (GND); the third and the fourth MOS transistor being configured to receive at their gates the second and the first comparison binary value (Bx, Ax) respectively;
and wherein a connection of the feedback output interface (SCx) to the first (Vcc) and the second (GND) supply voltage line is controlled by the first (M1) and the fourth (M4) MOS transistors respectively.

8. A self-correcting triple modular redundancy cell (500) comprising three corrigible comparators (CC0, CC1, CC2) in accordance with any one of the preceding cells, wherein:
- the comparison stage (C0) of a given corrigible comparator (CCO) is connected to the data-forwarding stage (S0) of the same corrigible comparator (CCO) and to the data-forwarding stage (S2) of one of the remaining two corrigible comparators (CC2), for receiving its respective first comparison binary value (A2) as the second comparison binary value, such that each of the three comparison stages is connected to a respective different pair of data-forwarding stages; and wherein
- the correction stage (F0) of a given corrigible comparator (CCO) is configured to receive, as the two feedback binary values (SC2, SC1), the feedback binary values generated and provided by the comparison stages (C1, C2) of the remaining two corrigible comparators (CC1, CC2).

9. The self-correcting triple modular redundancy cell (600) of claim 8, wherein the three corrigible true single-phase clock comparators (TSPCx, TSPCy, TSPCz) are configured to receive a common clock signal (C).

10. The self-correcting triple modular redundancy cell (500) of claim 8, wherein each of the three corrigible comparators is configured to receive a respective clock-signal that is phase-shifted with respect to the other two clock signals.

11. The self-correcting triple modular redundancy cell (700) of claim 8 or 9, further comprising a single event transient filter unit connected to the data forwarding stages (S0, S1, S2).

12. The self-correcting triple modular redundancy cell (700) of claim 11, wherein the single event transient filter unit comprises a data-input delay unit (770, 772) connected to at least two of the three data-forwarding stages (S0, S1, S2) and configured to delay an electrical input signal, so that variations of the value of the input binary data (D) reach the three data-forwarding stages at different times (D0, D1, D2).

13. The self-correcting triple modular redundancy cell of claim 11 or 12, wherein the single event transient filter unit comprises at least one two-input guard gate configured to receive at its input the input binary data signal and a delayed input binary data signal and to provide its output to a respective data-forwarding stage.

14. The triple modular redundancy cell (500, 600) of any of the claims 8 to 13, further comprising a driving stage (560, 660) connected to the data output interfaces (110) of the comparison stages of the three corrigible comparators and configured to provide, a binary value (!Q) corresponding to the complementary value of that output binary value (Q0, Q1, Q2) provided at least twice by the three corrigible comparators (TSPC0, TSPC1, TSPC2).

15. A method (800) for operating a corrigible comparator, the method comprising:
- receiving (802) a clock signal;
- receiving (804) an input binary data signal;
- generating and providing (806), in dependence on an occurrence of a clock-based forwarding trigger event in the received clock signal, a first comparison binary value that is correlated to the value of the input binary data;
- receiving (808) the first comparison binary value and an external second comparison binary value for comparing to the first comparison binary value;
- providing (810) an output binary value that is correlated to the first and the second comparison binary value when they have an identical binary value;
- providing (812), a feedback binary value correlated to the first comparison binary value;
- receiving (814) two external feedback binary values; and
- providing (816), in dependence on an occurrence in the received clock signal of a clock-based correction trigger event different from the forwarding trigger event, as a corrected first comparison binary value, a corrected binary value correlated to the two external feedback binary values when they have the same binary value.
